(19) Europäisches Patentamt
European Patent Office
Office européen des brevets

(11) **EP 4 694 604 A1**

(12) **EUROPEAN PATENT APPLICATION**
published in accordance with Art. 153(4) EPC

(43) Date of publication:
**11.02.2026 Bulletin 2026/07**

(21) Application number: **24779167.6**

(22) Date of filing: **05.03.2024**

(51) International Patent Classification (IPC):
*H05K 9/00* (2006.01)     *B32B 15/20* (2006.01)
*B32B 15/082* (2006.01)   *B32B 27/18* (2006.01)
*B32B 27/30* (2006.01)    *H01F 1/26* (2006.01)

(52) Cooperative Patent Classification (CPC):
**B32B 15/082; B32B 15/20; B32B 27/18;
B32B 27/30; H01F 1/26; H05K 9/00**

(86) International application number:
**PCT/JP2024/008284**

(87) International publication number:
**WO 2024/203029 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.03.2023 JP 2023052023**

(71) Applicant: **FUJIFILM Corporation
Tokyo Tokyo 106-8620 (JP)**

(72) Inventors:
• **FUKAGAWA, Kiyotaka**
  **Minamiashigara-shi, Kanagawa 250-0193 (JP)**
• **MIKAMI, Tatsuo**
  **Minamiashigara-shi, Kanagawa 250-0193 (JP)**
• **BEN AMMAR, Youssef**
  **Minamiashigara-shi, Kanagawa 250-0193 (JP)**

(74) Representative: **Klunker IP
Patentanwälte PartG mbB
Destouchesstraße 68
80796 München (DE)**

(54) **ELECTROMAGNETIC WAVE SHIELDING MATERIAL, ELECTRONIC COMPONENT, AND ELECTRONIC DEVICE**

(57)     Provided are an electromagnetic wave shielding material including a magnetic layer containing magnetic particles and an acrylic resin between two metal layers, in which a content of an organic solvent in the magnetic layer is 5 ppm or more and less than 1,000 ppm on a mass basis, and an electronic component and an electronic apparatus which include the electromagnetic wave shielding material.

EP 4 694 604 A1

## Description

Technical Field

The present invention relates to an electromagnetic wave shielding material, an electronic component, and an electronic apparatus.

Background Art

PTL1 discloses a noise suppression sheet including at least one of a soft magnetic body or a dielectric.

Citation List

Patent Literature

PTL1: JP2010-97969A

Summary of the invention

Technical Problem

In recent years, an electromagnetic wave shielding material has attracted attention as a material for reducing the influence of an electromagnetic wave in various electronic components and various electronic apparatuses. An electromagnetic wave shielding material is capable of exhibiting the performance of shielding electromagnetic waves (hereinafter, also referred to as an "electromagnetic wave shielding ability" or a "shielding ability") by reflecting electromagnetic waves incident on the electromagnetic wave shielding material by the electromagnetic wave shielding material and/or by attenuating the electromagnetic waves inside the electromagnetic wave shielding material. For example, the noise suppression sheet described in PTL1 can function as an electromagnetic wave shielding material.

The electromagnetic wave shielding material can be exposed to a high temperature in a state of being incorporated into an electronic component or various electronic apparatuses. Therefore, it is desired that the electromagnetic wave shielding material can exhibit a high shielding ability after being placed at a high temperature. The electromagnetic wave shielding material that exhibits a high shielding ability against electromagnetic waves after being placed at a high temperature can contribute to a significant reduction in the influence of electromagnetic waves in electronic components and electronic apparatuses. Hereinafter, the fact that a high shielding ability is exhibited after the electromagnetic wave shielding material is placed at a high temperature is also referred to as high heat resistance or excellent heat resistance.

In addition, a force may be applied from the outside to the electromagnetic wave shielding material for forming, and even after the electromagnetic wave shielding material is formed and incorporated into an electronic component or an electronic apparatus, a force may be applied from the outside due to, for example, falling or collision. The durability to withstand such an external force can also be shown as an example, as a desired performance of the electromagnetic wave shielding material.

In consideration of the above circumstances, an object of an aspect according to the present invention is to provide an electromagnetic wave shielding material having excellent heat resistance and durability.

Solution to Problem

An aspect of the present invention is as follows.

[1] An electromagnetic wave shielding material comprising:

a magnetic layer containing magnetic particles and an acrylic resin between two metal layers,
in which a content of an organic solvent in the magnetic layer is 5 ppm or more and less than 1,000 ppm on a mass basis.

[2] The electromagnetic wave shielding material according to [1],
in which a weight-average molecular weight of the acrylic resin is 100,000 or more.
[3] The electromagnetic wave shielding material according to [1] or [2],
in which a weight-average molecular weight of the acrylic resin is 800,000 or more and 2,000,000 or less.

[4] The electromagnetic wave shielding material according to any one of [1] to [3],
in which the content of the organic solvent in the magnetic layer is 10 ppm or more and 100 ppm or less.
[5] The electromagnetic wave shielding material according to any one of [1] to [4],
in which the organic solvent is selected from the group consisting of methyl ethyl ketone and cyclohexanone.
[6] The electromagnetic wave shielding material according to any one of [1] to [5], further comprising:
one or more layers containing a resin between the magnetic layer sandwiched between the two metal layers and one or both of the two metal layers.
[7] The electromagnetic wave shielding material according to any one of [1] to [6],
in which the electromagnetic wave shielding material has two or more multilayer structures that include the magnetic layer between the two metal layers.
[8] The electromagnetic wave shielding material according to any one of [1] to [7],
in which one or more of the metal layers are metal layers having a Cu content of 80.0% by mass or more.
[9] The electromagnetic wave shielding material according to any one of [1] to [8],
in which one or more of the metal layers are metal layers having an Al content of 80.0% by mass or more.
[10] The electromagnetic wave shielding material according to any one of [1] to [9],

in which a weight-average molecular weight of the acrylic resin is 800,000 or more and 2,000,000 or less,
the content of the organic solvent in the magnetic layer is 10 ppm or more and 100 ppm or less,
the organic solvent is selected from the group consisting of methyl ethyl ketone and cyclohexanone,
the electromagnetic wave shielding material has two or more multilayer structures that include the magnetic layer between the two metal layers, and
one or more of the metal layers are metal layers having a Cu content of 80.0% by mass or more.

[11] The electromagnetic wave shielding material according to any one of [1] to [9],

in which a weight-average molecular weight of the acrylic resin is 800,000 or more and 2,000,000 or less,
the content of the organic solvent in the magnetic layer is 10 ppm or more and 100 ppm or less,
the organic solvent is selected from the group consisting of methyl ethyl ketone and cyclohexanone,
the electromagnetic wave shielding material has two or more multilayer structures that include the magnetic layer between the two metal layers, and
one or more of the metal layers are metal layers having an Al content of 80.0% by mass or more.

[12] An electronic component comprising:
the electromagnetic wave shielding material according to any one of [1] to [11].
[13] An electronic apparatus comprising:
the electromagnetic wave shielding material according to any one of [1] to[11].Effects of Invention

According to one aspect of the present invention, it is possible to provide an electromagnetic wave shielding material having excellent heat resistance and durability. In addition, according to one aspect of the present invention, it is possible to provide an electronic component and an electronic apparatus, which include the electromagnetic wave shielding material.

Brief description of the drawings

FIG. 1 is an explanatory view of a measurement of peel strength.
FIG. 2 is an explanatory view of the measurement of the peel strength.

Description of embodiments

[Electromagnetic wave shielding material]

An aspect of the present invention relates to an electromagnetic wave shielding material comprising a magnetic layer containing magnetic particles and an acrylic resin between two metal layers, in which a content of an organic solvent in the magnetic layer is 5 ppm or more and less than 1,000 ppm on a mass basis.
In the present invention and the present specification, the "electromagnetic wave shielding material" shall refer to a material that is capable of exhibiting shielding ability against an electromagnetic wave of at least one frequency or at least a part of a range of a frequency band. The "electromagnetic wave" includes a magnetic field wave and an electric field wave. The "electromagnetic wave shielding material" can be a material that is capable of exhibiting shielding ability against one or both of a magnetic field wave of at least one frequency or at least a part of a range of a frequency band and an electric field wave of at least one frequency or at least a part of a range of a frequency band.

In the present invention and the present specification, "magnetic" means having a ferromagnetic property. Details of the magnetic layer will be described later.

The inventors of the present invention presume that the fact that the electromagnetic wave shielding material has a multilayer structure in which a magnetic layer is sandwiched between two metal layers can contribute for the electromagnetic wave shielding material to be capable of exhibiting a high shielding ability against electromagnetic waves. The details are as follows.

In order to obtain a high shielding ability against electromagnetic waves in the electromagnetic wave shielding material, it is desirable to increase the reflection at the interface in addition to increasing the ability to attenuate electromagnetic waves. That is, it is desirable that the electromagnetic wave repeatedly reflects at the interface and passes through the electromagnetic wave shielding material a large number of times to be largely attenuated. However, as the behavior of the metal layer and the magnetic layer with respect to the electromagnetic wave, the reflection of the magnetic field wave at the interface tends to be small although the metal layer has a large ability to attenuate the electromagnetic wave, and the reflection of the magnetic field wave at the interface tends to be larger than that in the metal layer although the magnetic layer has a smaller ability to attenuate the electromagnetic wave than the metal layer. Therefore, with the metal layer alone or the magnetic layer alone, it is difficult to achieve both high reflection and high attenuation of, particularly, the magnetic field wave among the electromagnetic waves. On the other hand, due to having a multilayer structure having the magnetic layer between two metal layers, the electromagnetic wave shielding material makes it possible to achieve both the above-described reflection at the interface and the above-described attenuation within the layer. The inventors of the present invention conceive this fact is the reason why the electromagnetic wave shielding material is capable of exhibiting a high shielding ability against magnetic field waves.

Further, the magnetic layer included in the multilayer structure contains an acrylic resin. It is considered that the main chain of the acrylic resin is not easily thermally decomposed due to the carbon-carbon saturated bond in the main chain. The inventors of the present invention consider that containing of the acrylic resin in the magnetic layer can contribute to the fact that the electromagnetic wave shielding material can exhibit a high shielding ability without a significant reduction even after being placed at a high temperature.

In addition, the inventors of the present invention consider that the content of the organic solvent in the magnetic layer included in the multilayer structure being 5 ppm or more and less than 1,000 ppm on a mass basis can contribute to the improvement of the durability of the electromagnetic wave shielding material. The inventors of the present invention presume that the content of the organic solvent of 5 ppm or more contributes to the improvement of the adhesiveness between the magnetic layer and the adjacent layer, and the content of the organic solvent of less than 1,000 ppm contributes to the difficulty of the plastic deformation of the magnetic layer, and these can improve the durability of the electromagnetic wave shielding material.

However, the present invention is not limited to the presumption described in the present specification.

<Magnetic layer>

(Magnetic particle)

As the magnetic particle, one kind selected from the group consisting of magnetic particles generally called soft magnetic particles, such as metal particles and ferrite particles, can be used, or two or more kinds therefrom can be used in combination. Since the metal particles generally have a saturation magnetic flux density of about 2 to 3 times as compared with ferrite particles, the metal particles can maintain specific magnetic permeability and exhibit shielding ability even under a strong magnetic field without magnetic saturation. Therefore, the magnetic particles to be contained in the magnetic layer are preferably metal particles. In the present invention and the present specification, a layer containing metal particles as the magnetic particles shall correspond to the "magnetic layer".

Metal particle

Examples of the metal particles as the magnetic particles include particles of Sendust (a Fe-Si-Al alloy), permalloy (a Fe-Ni alloy), molybdenum permalloy (a Fe-Ni-Mo alloy), a Fe-Si alloy, a Fe-Cr alloy, a Fe-containing alloy generally called the iron-based amorphous alloy, a Co-containing alloys generally called the cobalt-based amorphous alloy, an alloy generally called the nanocrystal alloy, iron, Permendur (a Fe-Co alloy). Among them, Sendust is preferable since it exhibits a high saturation magnetic flux density and a high specific magnetic permeability. The metal particle may contain, in addition to the constitutional element of the metal (including the alloy), elements contained in an additive that can be optionally added and/or elements contained in impurities that can be unintentionally mixed in a manufacturing process of the metal particle at any content rate. In the metal particle, the content of the constitutional element of the metal (including the alloy) is preferably 90.0% by mass or more and more preferably 95.0% by mass or more, and it may be 100% by mass or may be less than 100% by mass, 99.9% by mass or less, or 99.0% by mass or less.

In one form, the shielding ability of the electromagnetic wave shielding material against the electromagnetic wave can be evaluated using, as an indicator, the magnetic permeability (specifically, the real part of the complex specific magnetic permeability) of the magnetic layer included in the electromagnetic wave shielding material. The electromagnetic wave shielding material including a magnetic layer exhibiting a high magnetic permeability (specifically, a real part of a complex specific magnetic permeability) is preferable since a high shielding ability can be exhibited against electromagnetic waves.

In a case where a complex specific magnetic permeability is measured by a magnetic permeability measuring apparatus, a real part $\mu'$ and an imaginary part $\mu'$ are generally displayed. In the present invention and the present specification, a real part of a complex specific magnetic permeability shall refer to such a real part $\mu'$. Hereinafter, a real part of a complex specific magnetic permeability at a frequency of 3 megahertz (MHz) is also simply referred to as "magnetic permeability" or "magnetic permeability $\mu'$". The magnetic permeability can be measured by a commercially available magnetic permeability measuring apparatus or a magnetic permeability measuring apparatus having a known configuration. The measurement temperature is set to 25°C. By setting an atmospheric temperature around the measurement sample to the measurement temperature, the temperature of the measurement sample can be set to the measurement temperature by establishing a temperature equilibrium. From the viewpoint that still more excellent electromagnetic wave shielding ability can be exhibited, the magnetic permeability (the real part of complex specific magnetic permeability at a frequency of 3 MHz) of the magnetic layer included in the electromagnetic wave shielding material is preferably 40 or more, more preferably 100 or more in all values before and after thermal aging at 80°C, which are obtained by the method described in the column of Examples described later. In addition, the magnetic permeability can be, for example, 500 or less, 300 or less, or 200 or less, and it can exceed the values exemplified here. The electromagnetic wave shielding material having a high magnetic permeability is preferable since it can exhibit an excellent electromagnetic wave shielding ability.

From the viewpoint of forming a magnetic layer that exhibits a high magnetic permeability, the above-described magnetic particles are preferably particles having a flat shape (flat-shaped particles), and more preferably metal particles having a flat shape. In a case of arranging the long side direction of the flat-shaped particles to be closer to a state parallel to the in-plane direction of the magnetic layer, the magnetic layer can exhibit a higher magnetic permeability since the diamagnetic field can be reduced by aligning the long side direction of the particle with the vibration direction of the electromagnetic wave incident orthogonal to the electromagnetic wave shielding material. In the present invention and the present specification, the "flat-shaped particle" refers to a particle having an aspect ratio of 0.200 or less. The aspect ratio of the flat-shaped particles is preferably 0.150 or less, and more preferably 0.100 or less. The aspect ratio of the flat-shaped particles can be, for example, 0.010 or more, 0.020 or more, or 0.030 or more. It is possible to make the shape of the particle flat-shaped, for example, by carrying out the flattening process according to a known method. For the flattening process, for example, the description of JP2018-131640A can be referenced, for example, the description of paragraphs 0016 and 0017 and the description of Examples of the same publication can be referenced. Examples of the magnetic layer that exhibits a high magnetic permeability include a magnetic layer containing flat-shaped particles of Sendust.

As described above, from the viewpoint of forming a layer that exhibits a high magnetic permeability as the magnetic layer, it is preferable to arrange the long side direction of the flat-shaped particles to be closer to a state parallel to the in-plane direction of the magnetic layer. From this point, the alignment degree which is a sum of an absolute value of the average value of alignment angles of the flat-shaped particles with respect to the surface of the magnetic layer and a variance of the alignment angles is preferably 30° or lower, more preferably 25° or lower, still more preferably 20° or lower, and even still more preferably 15° or lower. The alignment degree can be, for example, 3° or higher, 5° or higher, or 10° or higher, and it can be lower than the values exemplified here. A method of controlling the alignment degree will be described later.

In the present invention and the present specification, the aspect ratio of the magnetic particle and the alignment degree are determined according to the following methods.

A cross section of a magnetic layer is exposed according to a known method. In a randomly selected region of this cross section, a cross-sectional image is acquired as a scanning electron microscope (SEM) image. The imaging conditions are set to be an acceleration voltage of 2 kV and a magnification of 1,000 times, and an SEM image is obtained as the backscattered electron image.

Reading is carried out in grayscale with the cv2.imread () function of Image processing library OpenCV 4 (manufactured by Intel Corporation) by setting the second argument to 0, and a binarized image is obtained with the cv2.threshold () function, using an intermediate brightness between the high-brightness portion and the low-brightness portion as a boundary. A white portion (high-brightness portion) in the binarized image is defined as a magnetic particle.

Regarding the obtained binarized image, a rotational circumscribed rectangle corresponding to a portion of each magnetic particle is determined according to the cv2.minAreaRect () function, and the long side length, the short side length, and the rotation angle are determined as the return values of the cv2.minAreaRect () function. In a case of determining the total number of magnetic particles included in the binarized image, it shall be assumed that particles in which only a part of the particle is included in the binarized image are also included. Regarding the particles in which only a part of the particle is included in the binarized image, the long side length, the short side length, and the rotation angle of the portion included in the binarized image are determined. The ratio of the short side length to the long side length (short side length/long side length) determined in this way shall be denoted as the aspect ratio of each magnetic particle. In the present invention and the present specification, in a case where the number of magnetic particles which have an aspect ratio of 0.200 or less and is defined as flat-shaped particles is 10% or more on a number basis with respect to the total number of magnetic particles included in the binarized image, it shall be determined that the magnetic layer is a "magnetic layer including flat-shaped particles as the magnetic particles". In addition, from the rotation angle determined as above, an "alignment angle" is determined as a rotation angle with respect to a horizontal plane (the surface of the magnetic layer).

Particles having an aspect ratio of 0.200 or less, which are determined in the binarized image, are defined as flat-shaped particles. Regarding the alignment angles of all the flat-shaped particles included in the binarized image, the sum of the absolute value of the average value (arithmetic average) and the variance is determined. The sum determined in this way is referred to as the "alignment degree". It is noted that the coordinates of the circumscribed rectangle are calculated using the cv2.boxPoints () function, and an image in which the rotational circumscribed rectangle is superposed on the original image is created according to the cv2.drawContours () function, where a rotational circumscribed rectangle that is erroneously detected clearly is excluded from the calculation of the aspect ratio and the alignment degree. In addition, an average value (arithmetic average) of the aspect ratios of the particles defined as the flat-shaped particles shall be denoted as the aspect ratio of the flat-shaped particles to be contained in a magnetic layer to be measured. Such an aspect ratio is 0.200 or less, preferably 0.150 or less, and more preferably 0.100 or less. In addition, the aspect ratio can be, for example, 0.010 or more, 0.020 or more, or 0.030 or more.

The content of the magnetic particles in the magnetic layer can be, for example, 50 parts by mass or more, 60 parts by mass or more, 70 parts by mass or more, or 80 parts by mass or more, and can be, for example, 87 parts by mass or less, 85 parts by mass or less, 80 parts by mass or less, or 75 parts by mass or less, with respect to 100 parts by mass of the total mass of the magnetic layer. The magnetic layer can contain only one kind of magnetic particle, or can contain two or more kinds of magnetic particles at any ratio. In the present invention and the present specification, in a case where two or more kinds of components are contained, the content refers to a total content of the components. The contents of various components in the magnetic layer can be determined by a well-known method such as thermogravimetry/differential thermal analysis (TG/DTA) or extraction of various components using a solvent. "TG/DTA" is generally called thermogravimetry/differential thermal analysis. In a case where a composition of a composition for forming a magnetic layer, which has been used for forming the magnetic layer, is known, the contents of various components in the magnetic layer can be also determined from this known composition.

In one form, the magnetic layer can be a layer having insulating properties. In the present invention and the present specification, the "insulating properties" means that the electrical conductivity is smaller than 1 siemens (S)/m. The electrical conductivity of a certain layer is calculated according to the following expression from the surface electrical resistivity of the layer and the thickness of the layer. The electrical conductivity can be measured by a known method.

$$\text{Electrical conductivity [S/m]} = 1/(\text{surface electrical resistivity } [\Omega] \times \text{thickness [m]})$$

The inventors of the present invention presume that it is preferable that the magnetic layer is a layer having insulating properties in order for the electromagnetic wave shielding material to exhibit a higher electromagnetic wave shielding ability. From this point, the electrical conductivity of the magnetic layer is preferably smaller than 1 S/m, more preferably 0.5 S/m or less, still more preferably 0.1 S/m or less, and even still more preferably 0.05 S/m or less. The electrical conductivity of the magnetic layer can be, for example, $1.0 \times 10^{-12}$ S/m or more or $1.0 \times 10^{-10}$ S/m or more.

(Acrylic resin)

In the present invention and the present specification, a layer containing both magnetic particles and a resin shall correspond to the "magnetic layer". The resin can act as a binder in the magnetic layer. The magnetic layer of the electromagnetic wave shielding material contains an acrylic resin. In the present invention and the present specification, the "acrylic resin" refers to a polymer of (meth)acrylate. The polymer includes a homopolymer and a copolymer. In the present invention and the present specification, the "(meth)acrylate" refers to a compound containing one or more (meth) acryloyl groups in one molecule, and the term "(meth)acryloyl group" is used to indicate one or both of an acryloyl group and a methacryloyl group. In addition, the (meth)acryloyl group can be included in the (meth)acrylate in the form of a (meth)acryloyloxy group. The term "(meth)acryloyloxy group" shall be used to refer to either or both of an acryloyloxy group and a methacryloyloxy group.

Examples of the (meth)acrylate include acrylic acid esters such as methyl acrylate, ethyl acrylate, n(normal)-butyl acrylate, isobutyl acrylate, t(tertiary)-butyl acrylate, cyclohexyl acrylate, and benzyl acrylate; and methacrylic acid esters such as methyl methacrylate, ethyl methacrylate, propyl methacrylate, n-butyl methacrylate, isobutyl methacrylate, t-butyl methacrylate, cyclohexyl methacrylate, and benzyl methacrylate. These may be used alone or in combination of two or more. In one form, ethyl acrylate and n-butyl acrylate are preferable as the (meth)acrylate.

Examples of the acrylic resin include a copolymer of one or more selected from a hydroxy group-containing compound, an unsaturated carboxylic acid, and a compound represented by General Formula 1 and (meth)acrylate.

$$\text{General Formula 1} \qquad CH_2=C(X)R^1$$

In General Formula 1, $R^1$ represents a hydrogen atom or a methyl group, and X represents a hydrogen atom, an alkyl group having 1 to 20 carbon atoms, an aryl group, a -CN group, a -CO-$R^2$ group, a -O-CO-$R^3$ group, a -O-$R^4$ group, or a -$(CH_2)_n$-O-$R^5$ group. $R^2$, $R^3$, $R^4$, and $R^5$ each independently represent a hydrogen atom or an organic group having 1 to 20 carbon atoms, and the organic group may include a halogen atom, a glycidyl group, and the like. n represents an integer of 1 or more and 6 or less.

Examples of the hydroxy group-containing compound include 2-(hydroxyalkyl)acrylic acid esters such as $\alpha$-hydroxymethylstyrene, $\alpha$-hydroxyethylstyrene, and methyl 2-(hydroxyethyl)acrylate; 2-(hydroxyalkyl)acrylic acids such as 2-(hydroxyethyl)acrylic acid; and the like. These may be used alone or in combination of two or more kinds thereof.

Examples of the unsaturated carboxylic acid include acrylic acid, methacrylic acid, crotonic acid, $\alpha$-substituted acrylic acid, and $\alpha$-substituted methacrylic acid, and these may be used alone or in combination of two or more kinds thereof.

Examples of the compound represented by General Formula (1) include styrene, vinyltoluene, $\alpha$-methylstyrene, acrylonitrile, methyl vinyl ketone, ethylene, propylene, vinyl acetate, 2-chloroethyl vinyl ether, vinyl chloroacetate, allyl glycidyl ether, glycidyl methacrylate, and glycidyl acrylate, and these may be used alone or in combination of two or more.

As the acrylic resin contained in the magnetic layer, a commercially available acrylic resin or an acrylic resin synthesized by a known method can be used.

From the viewpoint of further improving heat resistance, the molecular weight of the acrylic resin is preferably 10,000 or more, more preferably 50,000 or more, and still more preferably 100,000 or more, more than 100,000, 300,000 or more, 500,000 or more, and 800,000 or more in this order, as a weight-average molecular weight. The weight-average molecular weight of the acrylic resin can be, for example, 3,000,000 or less, 2,500,000 or less, or 2,000,000 or less. However, from the viewpoint of improving heat resistance, it is preferable that the acrylic resin has a high molecular weight, and thus the weight-average molecular weight of the acrylic resin may exceed the range exemplified here.

The weight-average molecular weight in the present invention and the present specification is a value measured by gel permeation chromatography (GPC). In the measurement using the gel permeation chromatography (GPC), HLC (registered trademark) -8320GPC [manufactured by Tosoh Corporation] can be used as the measuring device, TSKgel (registered trademark) Super HZ-H [4.6 mm ID x 15 cm, manufactured by Tosoh Corporation], Super HZ4000 [4.6 mm ID x 15 cm, manufactured by Tosoh Corporation], and Super HZ2000 [4.6 mm ID x 15 cm, manufactured by Tosoh Corporation] are connected one by one, respectively, in series and can be used as the column, and tetrahydrofuran (THF) can be used as the eluent.

The measurement conditions can be a specimen concentration of 0.2% by mass, a flow rate of 0.35 mL/min, a sample injection amount of 10 $\mu$L, and a measurement temperature of 40°C, and a differential refractive index (RI) detector can be used as the detector.

The calibration curve can be created using "Standard sample TSK standard, polystyrene", "F-288", "F-80", "F-20", "F-4", "F-2", "A-5000", and "A-1000", manufactured by Tosoh Corporation.

From the viewpoint of further improving heat resistance and the viewpoint of self-supporting property of the magnetic layer, the content of the acrylic resin of the magnetic layer is preferably 5 parts by mass or more, more preferably 10 parts by mass or more, and still more preferably 15 parts by mass or more, with respect to 100 parts by mass of the total mass of the magnetic layer. In addition, from the viewpoint of further improving the shielding ability of the electromagnetic wave shielding material, the total content of the acrylic resin of the magnetic layer is preferably less than 30 parts by mass, more preferably 28 parts by mass or less, still more preferably 25 parts by mass or less, and still more preferably 20 parts by mass or less, with respect to 100 parts by mass of the total mass of the magnetic layer.

In addition to the above-described components, the magnetic layer can also contain any amount of one or more known additives such as a curing agent, a dispersing agent, a stabilizer, and a coupling agent.

For example, the magnetic layer can contain one or two or more kinds of coupling agents. As the coupling agent, the silane coupling agent is preferable, and a silane coupling agent having a hydrolyzable group is more preferable. By using the silane coupling agent having a hydrolyzable group, it is expected that the affinity between the magnetic particles and the acrylic resin is increased due to the reforming of the surface of the magnetic particles, and the mechanical properties and the like are improved. Examples of the hydrolyzable group include an alkoxy group, an acyloxy group, and a halogeno group.

The silane coupling agent may have a hydrophobic group as a functional group. Examples of the silane coupling agent having a hydrophobic group as a functional group include alkoxysilanes such as methyltrimethoxysilane (MTMS), dimethyldimethoxysilane, phenyltrimethoxysilane, methyltriethoxysilane, dimethyldiethoxysilane, phenyltriethoxysilane, n-propyltrimethoxysilanes, n-propyltriethoxysilane, hexyltrimethoxysilane, hexyltriethoxysilane, and decyltrimethoxysilane; chlorosilanes such as methyltrichlorosilane, dimethyldichlorosilane, trimethylchlorosilane, and phenyltrichlorosilane; and hexamethyldisilazane (HMDS).

Further, the silane coupling agent may have a vinyl group as a functional group. Examples of the silane coupling agent having a vinyl group as a functional group include alkoxysilanes such as methacryloxypropyltriethoxysilane, methacryloxypropyltrimethoxysilane, methacryloxypropylmethyldiethoxysilane, methacryloxypropylmethyldimethoxysilane, vinyltriethoxysilane, vinyltrimethoxysilane, vinylmethyldimethoxysilane; chlorosilanes such as vinyltrichlorosilane and vinylmethyldichlorosilane; and divinyltetramethyldisilazane.

Further, the silane coupling agent may have an amino group as a functional group. Examples of the silane coupling agent having an amino group as a functional group include aminopropyltriethoxysilane, aminopropyltrimethoxysilane, N-2-(aminoethyl)-3-aminopropylmethyldimethoxysilane, N-2-(aminoethyl)-3-aminopropyltrimethoxysilane, N-2-(aminoethyl)-8-aminooctyltrimethoxysilane, a both-terminal amine type aminoalkoxysilane (for example, FM-3311, FM-3321, or FM-3325, manufactured by JNC Corporation), and a polyfunctional amine type aminoalkoxysilane (for example, X-12-972F manufactured by Shin-Etsu Chemical Co., Ltd.).

In a case where the electromagnetic wave shielding material includes only one magnetic layer, the thickness of this one magnetic layer can be, for example, 5 $\mu$m or more, and it is preferably 10 $\mu$m or more and more preferably 20 $\mu$m or more from the viewpoint of further improving the shielding ability of the electromagnetic wave shielding material. Meanwhile, the thickness of this one magnetic layer can be, for example, 100 $\mu$m or less or 90 $\mu$m or less, and it is preferably less than 90 $\mu$m, more preferably 80 $\mu$m or less, and still more preferably 70 $\mu$m or less, from the viewpoint of further improving forming workability.

In a case where the electromagnetic wave shielding material includes two or more magnetic layers, the thickness of each of the two or more magnetic layers (that is, the thickness per one layer) can be, for example, 5 $\mu$m or more, and it is preferably 10 $\mu$m or more and more preferably 20 $\mu$m or more from the viewpoint of further improving the shielding ability of the electromagnetic wave shielding material. Meanwhile, this one magnetic layer can be, for example, 100 $\mu$m or less or 90 $\mu$m or less, and it is preferably less than 90 $\mu$m and more preferably 80 $\mu$m or less. The respective thicknesses of the two or more magnetic layers can be the same thickness or thicknesses different from each other.

The thickness of each layer included in the electromagnetic wave shielding material shall be determined by imaging a cross section exposed by a known method with a scanning electron microscope (SEM) and determining an arithmetic average of thicknesses of five randomly selected points in the obtained SEM image.

(Content of organic solvent in magnetic layer)

In the electromagnetic wave shielding material, a content of an organic solvent in a magnetic layer which is sandwiched between two metal layers and contains magnetic particles and an acrylic resin is 5 ppm or more and less than 1,000 ppm on a mass basis. The unit "ppm" is an abbreviation for "parts per million", and in the present invention and the present specification, ppm is on a mass basis, and is also simply referred to as ppm below.

From the viewpoint of improving durability, the content of the organic solvent in the magnetic layer is 5 ppm or more, and preferably 10 ppm or more. In addition, from the viewpoint of improving durability, the content of the organic solvent in the magnetic layer is less than 1,000 ppm, preferably 800 ppm or less, and more preferably 600 ppm or less, 400 ppm or less, 200 ppm or less, 100 ppm or less, and less than 100 ppm in this order.

The "content of the organic solvent in the magnetic layer" in the present invention and the present specification is obtained by the following method in an environment of an atmospheric temperature of 23°C.

The magnetic layer of the electromagnetic wave shielding material or the magnetic layer of the sample cut out from the electromagnetic wave shielding material is exposed by peeling off the adjacent layer or the like. The exposed magnetic layer is scraped off by about 0.03 to 0.5 g to obtain a magnetic-layer sample.

The obtained magnetic-layer sample is placed in a headspace glass vial and sealed. This is used as a headspace-gas chromatography/mass spectrometer (HS-GC/MS) sample.

Under the following conditions, HS-GC/MS sample HS-GC/MS measurement is performed, and the amount of the organic solvent is quantified by a multiple headspace extraction method (MHE method). The MHE method is a method in which the content of a target analyte in a sample can be measured from a peak area attenuation curve by repeatedly performing headspace analysis under the same conditions. The amount of each organic solvent can be calculated according to the description in the following reference.

Reference: Shen W., Wang C., Multiple Headspace Extraction for the Quantitative Determination of Residual Monomer and Solvents in Polystyrene Pellets Using the Agilent 7697A Headspace Sampler, Agilent Technologies publication 5991-0974EN (can be calculated according to the formula described on page 9)

The content of the organic solvent (unit: ppm) is calculated from the quantified amount of the organic solvent and the amount of the magnetic-layer sample. The amount of the organic solvent calculated in this way is defined as the content of the organic solvent in the magnetic layer to be measured.

Gas chromatograph mass spectrometer (GC/MS): headspace-GC/MS (HS-GC/MS) manufactured by Shimadzu Corporation

Headspace conditions: heating temperature of 250°C, heating time of 20 minutes
Measurement method: multiple headspace extraction method (MHE method)
Number of times of injections: 5 times
Gas pressure for pressurizing vial: 90 kPa
Loading time: 0.5 minutes
Injection time: 1 minute
GC/MS conditions:

Column: PoraBond Q (25 m, 3 $\mu$m, 0.25 mm inner diameter (ID)) manufactured by Agilent Technology Co., Ltd.
Oven temperature: 50°C (1 min) $\rightarrow$ heated at 35 °C/min $\rightarrow$ 300°C (5 min)
Linear velocity: 50 cm/sec
Split ratio: 10
Interface temperature: 300°C
Detector: electron ionization (EI)-MS (scan: m/z 29 to 600, selected ion monitoring (SIM): m/z 43, 55, 91)

The content of the organic solvent in the magnetic layer can be controlled, for example, by the drying conditions in a case of producing the magnetic layer.

In the present invention and the present specification, the "organic solvent" refers to an organic compound which is a liquid at room temperature. Regarding the organic solvent, "room temperature" means 23°C. Examples of the organic solvent contained in the magnetic layer include ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone. In one form, the organic solvent contained in the magnetic layer can be a ketone-based solvent such as acetone, methyl ethyl ketone, or cyclohexanone, and can be methyl ethyl ketone and/or cyclohexanone.

<Metal layer>

The electromagnetic wave shielding material has a multilayer structure in which the magnetic layer is sandwiched between two metal layers. The electromagnetic wave shielding material has one or more such multilayer structures and can also include two or more such multilayer structures. That is, the electromagnetic wave shielding material includes at least two metal layers and can also include three or more layers of metal layer, or it includes at least one magnetic layer and can also include two or more magnetic layers. The two or more layers of metal layer included in the electromagnetic wave shielding material have the same composition and thickness in one form and differ in composition and/or thickness in another form. The same applies to a case where the electromagnetic wave shielding material includes two or more magnetic layers, and the same applies to a case where two or more other layers such as a resin layer described later are included in the electromagnetic wave shielding material.

In the present invention and the present specification, the "metal layer" shall refer to a layer containing a metal. The metal layer can be a layer containing one or more kinds of metals as a pure metal consisting of a single metal element, as an alloy of two or more kinds of metal elements, or as an alloy of one or more kinds of metal elements and one or more kinds of non-metal elements.

The metal layer included in the electromagnetic wave shielding material can be a layer that contains one or more kinds of metals selected from the group consisting of various pure metals and various alloys. The metal layer can exhibit an attenuation effect in the electromagnetic wave shielding material. This point is preferable from the viewpoint of improving the shielding ability of the electromagnetic wave shielding material. Since the attenuation effect increases as the propagation constant increases and the propagation constant increases as the electrical conductivity is higher, it is preferable that the metal layer contains a metal element having a high electrical conductivity. From this point, it is preferable that the metal layer contains, as a main component, a pure metal of Ag, Cu, Au, or Al, or an alloy containing any one of these. The pure metal is a metal consisting of a single metal element and may contain a trace amount of impurities. In general, a metal having a purity of 99.0% or more consisting of a single metal element is called a pure metal. The purity is on a mass basis. The alloy is generally prepared by adding one or more kinds of metal elements or non-metal elements to a pure metal to adjust the composition, for example, in order to prevent corrosion or improve the hardness. The main component in the alloy is a component having the highest ratio on a mass basis, and it can be, for example, a component that occupies 80.0% by mass or more (for example, 99.8% by mass or less) in the alloy. From the viewpoint of economic efficiency, the alloy is preferably an alloy of a pure metal of Cu or Al or an alloy containing Cu or Al as a main component, and from the viewpoint of high electrical conductivity, it is more preferably an alloy of a pure metal of Cu or an alloy containing Cu as a main component.

In one form, the purity of the metal in the metal layer, that is, the content of the metal in the metal layer can be 99.0% by mass or more, 99.5% by mass or more, or 99.8% by mass or more with respect to the total mass of the metal layer. Unless otherwise specified, the content of metal in the metal layer shall refer to the content on a mass basis. For example, as the metal layer, a pure metal or an alloy processed into a sheet shape can be used. For example, as the metal layer, a commercially available metal foil or a metal foil produced by a known method can be used. Regarding a pure metal of Cu, sheets (so-called copper foils) having various thicknesses are commercially available. For example, such a copper foil can be used as the metal layer. The copper foil includes, according to manufacturing methods thereof, an electrolytic copper foil obtained by precipitating a copper foil on a cathode by electroplating and a rolled copper foil obtained by applying heat and pressure to an ingot and stretching the ingot thinly. Any copper foil can be used as the metal layer of the electromagnetic wave shielding material. In addition, for example, regarding Al, sheets (so-called aluminum foils) having various thicknesses are commercially available. For example, such an aluminum foil can be used as the metal layer.

From the viewpoint of reducing the weight of the electromagnetic wave shielding material, one or both (preferably both) of the two metal layers sandwiching the magnetic layer is preferably a metal layer containing the metal selected from the group consisting of Al and Mg, and more preferably a layer containing, as a main component, the metal selected from the group consisting of Al and Mg. The main component of the metal layer is a component having the highest ratio on a mass basis. In a layer containing, as a main component, a metal selected from the group consisting of Al and Mg, Al or Mg is a component having the highest ratio on a mass basis in this layer. Such a layer may contain only Al or Mg among Al and Mg, or may contain Al and Mg. A value (specific gravity/electrical conductivity) obtained by dividing the specific gravity by the electrical conductivity is small both in Al and Mg. As a metal in which this value is smaller is used, the weight of the electromagnetic wave shielding material that exhibits a high shielding ability can be further reduced. As a value calculated from the literature value, for example, a value (specific gravity/electrical conductivity) obtained by dividing the specific gravity by the electrical conductivity of each of Cu, Al, and Mg is as follows. Cu: $1.5 \times 10^{-7}$ m/S, Al: $7.6 \times 10^{-8}$ m/S, Mg: $7.6 \times 10^{-8}$ m/S. From the above values, it can be said that Al and Mg are preferred metals from the viewpoint of reducing the weight of the electromagnetic wave shielding material. The metal layer containing a metal selected from the group consisting of Al and Mg can contain only one of Al and Mg in one form and can contain both in another form. From the viewpoint of reducing the weight of the electromagnetic wave shielding material, one or both (preferably both) of the two metal layers sandwiching the magnetic layer is preferably a metal layer in which the content of the metal selected from the group consisting of Al and Mg is 80.0% by mass or more, and still more preferably a metal layer in which the content of the metal selected from the group consisting of Al and Mg is 90.0% by mass or more. The metal layer containing at least Al among Al and Mg can be a metal layer in which the Al content is 80.0% by mass or more, and it can be a metal layer in which the Al content is 90.0% by mass or more. The metal layer containing at least Mg among Al and Mg can be a metal layer in which the Mg content is 80.0% by mass or more, and it can be a metal layer in which the Mg content is 90.0% by mass or more. The content of the metal selected from the group consisting of Al and Mg, the Al content, and the Mg content can be each, for example, 99.9% by mass or less. The content of the metal selected from the group consisting of Al and Mg, the Al content, and the Mg content are each the content with respect to the total mass of the metal layer.

From one or more viewpoints of the viewpoint of economic efficiency, the viewpoint of high electrical conductivity, and the viewpoint of reducing the weight of the electromagnetic wave shielding material, one or both (preferably both) of the two metal layers sandwiching the magnetic layer is preferably a metal layer containing the metal selected from the group consisting of Al, Mg, and Cu, and more preferably a layer containing, as a main component, the metal selected from the group consisting of Al, Mg, and Cu. In a layer containing, as a main component, a metal selected from the group consisting of Al, Mg, and Cu, Al, Mg, or Cu is a component having the highest ratio on a mass basis in this layer. Such a layer can contain only one kind of metal or two or three kinds of metals among Al, Mg, and Cu. From the one or more viewpoints, one or both (preferably both) of the two metal layers sandwiching the magnetic layer is preferably a metal layer in which the content of the metal selected from the group consisting of Al, Mg, and Cu is 80.0% by mass or more, and still more preferably a metal layer in which the content of the metal selected from the group consisting of Al, Mg, and Cu is 90.0% by mass or more. The metal layer containing at least Al among Al, Mg, and Cu can be a metal layer in which the Al content is 80.0% by mass or more, and it can be a metal layer in which the Al content is 90.0% by mass or more. The metal layer containing at least Mg among Al, Mg, and Cu can be a metal layer in which the Mg content is 80.0% by mass or more, and it can be a metal layer in which the Mg content is 90.0% by mass or more. The metal layer containing at least Cu among Al, Mg, and Cu can be a metal layer in which the Cu content is 80.0% by mass or more, and it can be a metal layer in which the Cu content is 90.0% by mass or more. The content of the metal selected from the group consisting of Al, Mg, and Cu, the Al content, the Mg content, and the Cu content can be each, for example, 99.9% by mass or less. The content of the metal selected from the group consisting of Al, Mg, and Cu, the Al content, the Mg content, and the Cu content are each the content with respect to the total mass of the metal layer.

From the viewpoint of further improving the processability of the metal layer and the shielding ability of the electromagnetic wave shielding material, the thickness of the metal layer in terms of the thickness per one layer is preferably 4 $\mu$m or more, more preferably 5 $\mu$m or more, and still more preferably 10 $\mu$m or more. On the other hand, from the viewpoint of the processability of the metal layer, the thickness of the metal layer in terms of the thickness per one layer is preferably 200 $\mu$m or less, more preferably 100 $\mu$m or less, and still more preferably 50 $\mu$m or less. In the electromagnetic wave shielding material, the thicknesses of the plurality of metal layers can be the same thickness or thicknesses different from each other.

In one form, one or both of the outermost layers can be a metal layer in the electromagnetic wave shielding material. This point can contribute to the fact that the electromagnetic wave shielding material can exhibit a high shielding ability against a magnetic field wave in a low frequency region of about 100 kHz to 1 MHz. In addition, the fact that at least one of the outermost layers of the electromagnetic wave shielding material is a metal layer can contribute to suppressing edge peeling in a formed article obtained by forming processing. In one form, one or both of the outermost layers of the electromagnetic wave shielding material can be a metal layer that sandwiches a magnetic layer together with another metal layer.

In one form, in the multilayer structure in which the magnetic layer is sandwiched between the two metal layers of the electromagnetic wave shielding material, one or both of the two metal layers and the magnetic layer can be disposed as layers directly in contact with each other. That is, one or both of the two metal layers and the magnetic layer can be adjacent to each other without interposing another layer. In addition, in one form, a multilayer structure in which the magnetic layer is sandwiched between the two metal layers of the electromagnetic wave shielding material can also include one or more layers containing a resin between one or both of the two metal layers and the magnetic layer. The layer containing a resin is a layer containing one or more kinds of resins. Hereinafter, a specific form of the layer containing a resin will be described.

<Layer containing resin>

(Pressure-sensitive adhesive layer)

A pressure-sensitive adhesive layer can be mentioned as one form of the layer containing a resin. In the present invention and the present specification, the "pressure-sensitive adhesive layer" refers to a layer having tackiness on a surface at normal temperature. Regarding the tackiness, the "normal temperature" shall be defined as 23°C. In a case where such a layer comes into contact with an adherend, the layer adheres to the adherend due to the adhesive force thereof. In general, the tackiness is the property of exhibiting an adhesive force in a short time after coming into contact with an adherend with a very light force, and in the present invention and the present specification, the above-described "having tackiness" refers to that the result is No. 1 to No. 32 in a tilted ball tack test (measurement environment: a temperature of 23°C and a relative humidity of 50%) specified in JIS Z 0237: 2009. In a case where another layer is laminated on the surface of the pressure-sensitive adhesive layer, the surface of the pressure-sensitive adhesive layer exposed, for example, by peeling off the other layer can be subjected to the above-described test. In a case where another layer is laminated on each of one surface and the other surface of the pressure-sensitive adhesive layer, the layer on the side of either surface may be peeled off.

As the pressure-sensitive adhesive layer, it is possible to use those obtained by applying a composition for forming a pressure-sensitive adhesive layer containing a pressure sensitive adhesive such as an acrylic pressure sensitive adhesive, a rubber-based pressure-sensitive adhesive, a silicone-based pressure-sensitive adhesive, or a urethane-based pressure-sensitive adhesive and processing it into a film shape.

The composition for forming a pressure-sensitive adhesive layer can be applied onto, for example, a support. The coating can be carried out using a known coating device such as a blade coater or a die coater. The coating can be carried out by a so-called roll-to-roll method or a batch method.

Examples of the support onto which the composition for forming a pressure-sensitive adhesive layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. As the support, it is possible to use a support in which a surface (a surface to be coated) onto which the composition for forming a pressure-sensitive adhesive layer is applied is subjected to a peeling treatment according to a known method. One form of the peeling treatment includes forming a release layer. In addition, a commercially available peeling-treated resin film can also be used as the support. In a case of using a support in which the surface to be coated is subjected to the peeling treatment, it is possible to easily separate the pressure-sensitive adhesive layer and the support after the film formation.

By applying a composition for forming a pressure-sensitive adhesive layer, in which a pressure sensitive adhesive is dissolved and/or dispersed in a solvent, onto the surface to be coated and carrying out drying, a pressure-sensitive adhesive layer can be formed. Alternatively, a pressure sensitive adhesive tape including a pressure-sensitive adhesive layer can also be used. As the pressure sensitive adhesive tape, for example, it is possible to use a double-sided tape. The double-sided tape has pressure-sensitive adhesive layers on both sides of the support. In addition, as the pressure sensitive adhesive tape, it is possible to use a pressure sensitive adhesive tape having a pressure-sensitive adhesive layer on one surface of a support. Examples of the support include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide, a non-woven fabric, and paper. As the pressure sensitive adhesive tape having a pressure-sensitive adhesive layer on one surface or both surfaces of a support, it is possible to use a commercially available product, or it is possible to use a pressure sensitive adhesive tape produced by a known method.

The thickness of the pressure-sensitive adhesive layer is not particularly limited, and the thickness per layer can be, for example, 1 μm or more and 30 μm or less.

(Adhesive layer)

An adhesive layer can also be mentioned as one form of the layer containing a resin. In the present invention and the present specification, the "adhesive layer" is a layer in which a liquid or gel-like adhesive is solidified after coming into contact with an adherend and undergoing a state change such as drying or curing, at that time, adhesiveness to the adherend is exhibited by an anchoring effect, a physical interaction, or formation of a chemical bond to the adherend. In one form, the adhesive layer can be a layer having no tackiness on the surface at normal temperature.

The adhesive contains a resin that is solidified after being dried or cured. Examples of such a resin include a vinyl acetate resin, an ethylene vinyl acetate resin, an epoxy resin, a cyanoacrylate resin, an acrylic resin, a polyurethane resin, a chloroprene rubber, and a styrene butadiene rubber. These resins may be in the form of a liquid or a gel in the resin itself. Alternatively, the solid resin may be dissolved in a solvent to be in a liquid or gel form. Examples of the solvent contained in the adhesive include water, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone, alcohol-based solvents such as ethanol, methanol, and propanol, and halogen-based solvents such as dichloromethane, trichloroethylene, and dichlorofluoroethane.

The thickness of the adhesive layer is not particularly limited, and the thickness per layer can be, for example, 1 μm or more and 30 μm or less.

(Resin layer)

A resin layer can also be mentioned as one form of the layer containing a resin. In the present invention and the present specification, the "resin layer" is a resin film obtained by forming a thermoplastic resin such as a synthetic resin into a film shape, and the resin film has a film-like structure by itself and does not have tackiness at normal temperature.

Examples of the thermoplastic resin contained in the resin film include various resins such as a polyethylene (PE) resin, a polypropylene (PP) resin, a polyvinyl chloride (PVC) resin, a polystyrene (PS) resin, a vinyl acetate resin, a polyurethane resin, a polyvinyl alcohol resin, an ethylene vinyl acetate resin, styrene butadiene rubber, acrylonitrile butadiene rubber, silicone rubber, an olefin-based elastomer (PP), a styrene-based elastomer, an acrylonitrile-butadiene-styrene (ABS) resin, polyethylene terephthalate (PET), a polyester resin such as polyethylene naphthalate (PEN), a polycarbonate (PC) resin, an acrylic resin such as polymethyl methacrylate (PMMA), cyclic polyolefin, and triacetyl cellulose (TAC).

The resin layer can be bonded to a metal layer or a magnetic layer by interposing a pressure-sensitive adhesive layer or an adhesive layer. In addition, since the resin layer is a layer containing a thermoplastic resin, the resin layer has the property of being softened by heating and flows and follows minute protrusions and recessions on the surface of the adherend by being pressed against the adherend in a state of being heated, thereby capable of exhibiting an adhesive force due to the anchoring effect, and then it is cooled, whereby the adhered state can be maintained. Therefore, in one form, the resin layer and the other layer can be bonded to each other without interposing the pressure-sensitive adhesive layer or the adhesive layer.

The thickness of the resin layer in terms of the thickness per one resin layer is preferably 10 μm or greater and more preferably 12 μm or greater. The thickness of the resin layer in terms of the thickness per one resin layer is preferably 250 μm or less, more preferably 230 μm or less, still more preferably 210 μm or less, and even still more preferably 190 μm or less. In one form, the electromagnetic wave shielding material can include, in a multilayer structure in which the magnetic layer is sandwiched between the two metal layers, one or more resin layers having a thickness in the above range between one or both of the two metal layers and the magnetic layer. For example, the multilayer structure can include one magnetic layer having a thickness in the above range between one metal layer of the two metal layers and the magnetic layer and/or between the other metal layer and the magnetic layer.

<Specific example of layer configuration>

The total number of the magnetic layers included in the electromagnetic wave shielding material is such that one or more layers are included, two or more layers can be included, and for example, four or less layers can be included.

On the other hand, the total number of the metal layers included in the electromagnetic wave shielding material is such that two or more layers are included, and for example, two to five layers can be included.

In a case where the electromagnetic wave shielding material includes only one magnetic layer, this one magnetic layer is a magnetic layer sandwiched between the two metal layers.

In a case where the electromagnetic wave shielding material includes two or more magnetic layers, at least one layer of these two or more magnetic layers is a magnetic layer sandwiched between the two metal layers. Specifically, all or only a part of the magnetic layers included in the electromagnetic wave shielding material is a magnetic layer sandwiched between the two metal layers.

In one form, in a multilayer structure in which the magnetic layer is sandwiched between two metal layers, the magnetic layer can be in direct contact with both metal layers. In this case, specific examples of the layer configuration of the electromagnetic wave shielding material include the following examples.

Example A1: "Metal layer/magnetic layer/metal layer"
Example A2: "Metal layer/magnetic layer/metal layer/magnetic layer/metal layer"
Example A3: "Metal layer/magnetic layer/metal layer/magnetic layer/metal layer/magnetic layer/metal layer"

In an electromagnetic wave shielding material having two or more multilayer structures that include the magnetic layer between two metal layers, for example, as in Example A2 and Example A3, a metal layer that sandwiches a magnetic layer in a certain multilayer structure can also be a metal layer that sandwiches a magnetic layer in another multilayer structure. In the electromagnetic wave shielding material, the total number of multilayer structures including the magnetic layer between two metal layers can be, for example, 1 to 4. The total number of the multilayer structures is one in Example A1, two in Example A2, and three in Example A3. It is preferable that the total number of the multilayer structures is two or more (for example, two, three, or four) from the viewpoint of further improving the shielding ability of the electromagnetic wave shielding material. In the above, the symbol "/" means that the layer described on the left side of this symbol and the layer described on the right side of this symbol are in direct contact with each other without another layer being interposed therebetween. This point is also the same in the following description unless otherwise noted.

In another form, a multilayer structure in which the magnetic layer is sandwiched between the two metal layers of the electromagnetic wave shielding material can include one or more layers containing a resin between one or both of the two metal layers and the magnetic layer. In the above-described multilayer structure, one of the two metal layers may be adjacent to the magnetic layer without interposing another layer, and one or more layers containing a resin may be included between the other metal layer and the magnetic layer. In addition, the multilayer structure may include one or more layers containing a resin between each of the two metal layers and the magnetic layer. The layer containing a resin, which is located between the metal layer and the magnetic layer, is preferably at least a resin layer. In one form, the electromagnetic wave shielding material can include one or more layers containing a polyester resin between one or both of the two metal layers and the magnetic layer, and the layer containing a polyester resin is preferably a resin layer.

The multilayer structure can include a pressure-sensitive adhesive layer and/or an adhesive layer between the resin layer and the metal layer. In one form, in the multilayer structure, the pressure-sensitive adhesive layer and/or the adhesive layer may be included between the resin layer and the magnetic layer. In another form, in the multilayer structure, the resin layer and the magnetic layer can be in direct contact with each other. That is, the resin layer and the magnetic layer can be adjacent to each other without interposing another layer.

The electromagnetic wave shielding material can include, for example, a total of 1 to 12 layers containing a resin. The total number of layers of resin layers (preferably the resin layers having the thickness described above) included in the electromagnetic wave shielding material can be, for example, one to four layers. The total number of layers of layers selected from the group consisting of the pressure-sensitive adhesive layer and the adhesive layer, which are included in the electromagnetic wave shielding material, can be, for example, one to four layers or one to eight layers.

Examples of the disposition of the "magnetic layer", the "metal layer", the "resin layer", and the "pressure-sensitive adhesive layer or adhesive layer" in the electromagnetic wave shielding material include the following examples. In the following examples, the "pressure-sensitive adhesive layer" may include a support, and the "pressure-sensitive adhesive layer" may be a pressure sensitive adhesive tape having a pressure-sensitive adhesive layer on one or both surfaces of the support. For example, as in Example B3, metal layers that sandwich a certain magnetic layer can be metal layers that sandwich another magnetic layer. For example, in Example B3, the metal layer 2 is one of the two metal layers that sandwich the magnetic layer 1, and it is also one of the two metal layers that sandwich the magnetic layer 2. In addition, in Example B3, one of the outermost layers of the electromagnetic wave shielding material is the metal layer 1 that sandwiches the magnetic layer 1 together with the metal layer 2, and the other of the outermost layers of the electromagnetic wave shielding material is the metal layer 3 that sandwiches the magnetic layer 2 together with the metal layer 2.

Example B1: "Metal layer 1/pressure-sensitive adhesive layer 1 or adhesive layer 1/resin layer 1/magnetic layer 1/resin layer 2/pressure-sensitive adhesive layer 2 or adhesive layer 2/metal layer 2"

Example B2: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2"

Example B3: "Metal layer 1/pressure-sensitive adhesive layer 1 or adhesive layer 1/resin layer 1/magnetic layer 1/resin layer 2/pressure-sensitive adhesive layer 2 or adhesive layer 2/metal layer 2/pressure-sensitive adhesive layer 3 or adhesive layer 3/resin layer 3/magnetic layer 2/resin layer 4/pressure-sensitive adhesive layer 4 or adhesive layer 4/metal layer 3"

Example B4: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2/magnetic layer 2/resin layer 3/pressure-sensitive adhesive layer 3 or adhesive layer 3/metal layer 3"

Example B5: "Metal layer 1/pressure-sensitive adhesive layer 1 or adhesive layer 1/resin layer 1/magnetic layer 1/metal layer 2/pressure-sensitive adhesive layer 2 or adhesive layer 2/resin layer 2/magnetic layer 2/metal layer 3/pressure-sensitive adhesive layer 3 or adhesive layer 3/resin layer 3"

Example B6: "Metal layer 1/pressure-sensitive adhesive layer 1 or adhesive layer 1/resin layer 1/magnetic layer 1/metal layer 2/magnetic layer 2/resin layer 2/pressure-sensitive adhesive layer 2 or adhesive layer 2/metal layer 3"

Example B7: "Metal layer 1/pressure-sensitive adhesive layer 1 or adhesive layer 1/resin layer 1/magnetic layer 1/metal layer 2/magnetic layer 2/metal layer 3/pressure-sensitive adhesive layer 2 or adhesive layer 2/resin layer 2"

Example B8: "Metal layer 1/pressure-sensitive adhesive layer 1 or adhesive layer 1/resin layer 1/magnetic layer 1/resin layer 2/pressure-sensitive adhesive layer 2 or adhesive layer 2/metal layer 2/magnetic layer 2/resin layer 3/pressure-sensitive adhesive layer 3 or adhesive layer 3/metal layer 3"

<Manufacturing method for electromagnetic wave shielding material>

(Film forming method for magnetic layer)

The magnetic layer can be produced, for example, by drying a coating layer that is provided by applying a composition for forming a magnetic layer. The composition for forming a magnetic layer can contain the components described above and can further contain one or more kinds of solvents. Examples of the solvent include the various organic solvents described above as the organic solvent contained in the magnetic layer. One kind of solvent or two or more kinds of solvents selected in consideration of the solubility of the component that is used in the preparation of the composition for forming a magnetic layer can be mixed at any ratio and used. The solvent content of the composition for forming a magnetic layer is not particularly limited and may be determined in consideration of the coatability of the composition for forming a magnetic layer.

The composition for forming a magnetic layer can be prepared by sequentially mixing various components in any order or simultaneously mixing them. In addition, as necessary, a dispersion treatment can be carried out using a known dispersing machine such as a ball mill, a bead mill, a sand mill, or a roll mill, and/or a stirring treatment can be also carried out using a known stirrer such as a shaking type stirrer.

The composition for forming a magnetic layer can be applied onto, for example, a support. The coating can be carried out using a known coating device such as a blade coater or a die coater. The coating can be carried out by a so-called roll-to-roll method or a batch method.

Examples of the support onto which the composition for forming a magnetic layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. For these resin films, reference can be made to paragraphs 0081 to 0086 of JP2015-187260A. As the support, it is possible to use a support in which a surface (a surface to be coated) onto which the composition for forming a magnetic layer is applied is subjected to a peeling treatment according to a known method. One form of the peeling treatment includes forming a release layer. For the release layer, reference can be made to paragraph 0084 of JP2015-187260A. In addition, a commercially available peeling-treated resin film can also be used as the support. In a case of using a support in which the surface to be coated is subjected to the peeling treatment, it is possible to easily separate the magnetic layer and the support after the film formation.

A coating layer formed by applying the composition for forming a magnetic layer can be subjected to a drying treatment according to a known method such as heating or warm air blowing. The drying treatment can be carried out, for example, under conditions in which the solvent contained in the composition for forming a magnetic layer can be volatilized. As an example, the drying treatment can be carried out for 6 minutes to 2 hours in a heated atmosphere having an atmospheric temperature of 80°C to 150°C. The content of the organic solvent in the magnetic layer contained in the electromagnetic wave shielding material can be controlled by drying conditions such as temperature and time in the drying treatment.

The alignment degree of the flat-shaped particle described above can be controlled by a solvent kind, solvent amount, liquid viscosity, coating thickness, and the like of the composition for forming a magnetic layer. For example, in a case where the boiling point of the solvent is low, convection occurs due to drying, and thus the value of the alignment degree tends to be large. In a case where the solvent amount is small, the value of the alignment degree tends to increase due to physical interference between adjacent flat-shaped particles. On the other hand, in a case where the liquid viscosity is low, the rotation of flat-shaped particles is more likely to occur, and thus the value of the alignment degree tends to be small. The value of the alignment degree tends to be small as the coating thickness decreases. In addition, carrying out a pressurization treatment described later can contribute to reducing the value of the alignment degree. In a case of adjusting the various manufacturing conditions described above, the alignment degree of the flat-shaped particles can be controlled within the range described above.

(Pressurization treatment of magnetic layer)

The magnetic layer can also be subjected to a pressurization treatment after film formation. In a case of subjecting the magnetic layer containing the magnetic particles to a pressurization treatment, it is possible to increase the density of the magnetic particles in the magnetic layer, and it is possible to obtain a higher magnetic permeability. In addition, in the magnetic layer containing the flat-shaped particles, it is possible to reduce the value of the alignment degree by the pressurization treatment, and it is possible to obtain a higher magnetic permeability.

The pressurization treatment can be carried out by applying pressure in the thickness direction of the magnetic layer using a plate-shape pressing machine, a roll pressing machine, or the like. In the plate-shape pressing machine, an object to be pressurized can be disposed between two flat press plates that are disposed vertically, and the two press plates can be put together by mechanical or hydraulic pressure to apply pressure to the object to be pressurized. In the roll pressing machine, an object to be pressurized is allowed to pass between the rotating pressurization rolls that are disposed vertically, and at that time, mechanical or hydraulic pressure is applied to the pressurization rolls, or the distance between the pressurization rolls is made to be smaller than the thickness of the object to be pressurized, whereby the pressure can be applied.

The pressure during the pressurization treatment can be set freely. For example, in a case of a plate-shape pressing machine, it is, for example, 1 to 50 newtons (N)/mm$^2$. In a case of a roll pressing machine, it is, for example, 20 to 400 N/mm in terms of the linear pressure.

The pressurization time can be set freely. It takes, for example, 5 seconds to 30 minutes in a case where a plate-shape pressing machine is used. In a case where a roll pressing machine is used, the pressurization time can be controlled by the transport speed of the object to be pressurized, where the transport speed is, for example, 10 cm/min to 200 m/min.

The materials of the press plate and the pressurization roll can be randomly selected from metal, ceramics, plastic, and rubber.

In the pressurization treatment, it is also possible to carry out a pressurization treatment by applying a temperature to both of upper and lower press plates of a plate-shape pressing machine or one press plate thereof, or one roll of upper and lower rolls of a roll pressing machine. The magnetic layer can be softened by heating, which makes it possible to obtain a high compression effect in a case where pressure is applied. The temperature at the time of heating can be set freely, and it is, for example, 50°C or higher and 200°C or lower. The temperature at the time of heating can be the internal temperature of the press plate or the roll. Such a temperature can be measured with a thermometer installed inside the press plate or the roll.

After the heating and pressurization treatment with the plate-shape pressing machine, the press plates can be spaced apart from each other, for example, in a state where the temperature of the press plates is high, whereby the magnetic layer can be taken out. Alternatively, the press plate can be cooled by a method such as water cooling or air cooling while maintaining the pressure, and then the press plates can be spaced apart to take out the magnetic layer.

In the roll pressing machine, the magnetic layer can be cooled immediately after pressing, by a method such as water cooling or air cooling.

It is also possible to repeat the pressurization treatment two or more times.

In a case where the magnetic layer is formed into a film on a release film, it is possible to carry out a pressurization treatment, for example, in a state where the magnetic layer is laminated on the release film. Alternatively, the magnetic layer can also be peeled off from the release film and can be subjected to a pressurization treatment as a single layer of the magnetic layer.

(Bonding of various layers)

A pressure-sensitive adhesive layer or an adhesive layer can be used for bonding various layers. The pressure-sensitive adhesive layer and the adhesive layer are as described above.

In addition, in the electromagnetic wave shielding material, two layers adjacent to each other can be also adhered to each other, for example, by applying pressure and heat to carry out crimping. A plate-shape pressing machine, a roll pressing machine, or the like can be used for the crimping. For example, in a case where the magnetic layer is disposed as a layer that is in direct contact with the adjacent layer, the magnetic layer is softened in a crimping step, and the contact with the surface of the adjacent layer is promoted, whereby the magnetic layer and the adjacent layer can be bonded to each other without interposing another layer. The pressure at the time of crimping can be set freely. It is, for example, 1 to 50 $N/mm^2$ in a case of a plate-shape pressing machine. In a case of a roll pressing machine, it is, for example, 20 to 400 N/mm in terms of the linear pressure. The pressurization time at the time of crimping can be set freely. It takes, for example, 5 seconds to 30 minutes in a case where a plate-shape pressing machine is used. In a case where a roll pressing machine is used, the pressurization time can be controlled by a transport speed of an object to be pressurized, and the transport speed is, for example, 10 cm/min to 200 m/min. The temperature at the time of crimping can be selected freely, and it is, for example, 20°C or higher and 200°C or lower. The temperature at the time of crimping can be, for example, the internal temperature of the press plate or the roll.

The electromagnetic wave shielding material can be incorporated into, in any shape, an electronic component or an electronic apparatus. The electromagnetic wave shielding material can have a sheet shape, where the size thereof is not particularly limited. In the present invention and the present specification, the "sheet" has the same meaning as the "film". In addition, the electromagnetic wave shielding material can be a three-dimensionally formed article obtained by three-dimensionally forming a sheet-shaped electromagnetic wave shielding material, or it can also be a sheet-shaped electromagnetic wave shielding material for three-dimensional forming. As a three-dimensional forming method, it is possible to use various forming methods such as mold press forming, vacuum forming, and air pressure forming. Regarding the forming method, for example, the forming that is carried out without heating a forming target and/or a mold or carried out by heating a forming target and/or a mold without raising the temperature too much is generally called cold forming. Examples of the forming method of the cold forming include draw forming and bulge forming. The draw forming is a forming method in which a sheet-shaped forming target is pressed using a pair of molds of a female die and a male die, thereby being formed into bottomed containers having various shapes such as a cylinder, a square cylinder, and a conical shape. In contrast, a method of forming a formed article having a shape in which a curved surface protrudes from a flat surface, from a sheet-shaped forming target is bulge forming. The bulge forming can be carried out by pressing with only a male die without a female die. The draw forming is roughly classified into deep draw forming and shallow draw forming. A formed article having a shallow depth is formed by the shallow draw forming, and a formed article having a deep depth (for example, having a depth that is deeper than a diameter of a cylinder or a cone, or a length of one side of a pyramid) is formed by the deep draw forming. Known techniques can be applied to the three-dimensional forming method.

[Electronic component]

One aspect of the present invention relates to an electronic component including the electromagnetic wave shielding material. Examples of the electronic component include an electronic component included in an electronic apparatus such as a mobile phone, a mobile information terminal, and a medical device, and various electronic components such as a semiconductor element, a capacitor, a coil, and a cable. The electromagnetic wave shielding material is three-dimensionally formed into any shape, for example, according to the shape of the electronic component, thereby capable of being disposed in the inside of the electronic component, or it is three-dimensionally formed into a shape of a cover material, thereby capable of being disposed as a cover material that covers the outside of the electronic component. Alternatively, it can be three-dimensionally formed into a tubular shape, thereby being disposed as a cover material that covers the outside of the cable.

[Electronic apparatus]

One aspect of the present invention relates to an electronic apparatus including the electromagnetic wave shielding material. Examples of the electronic apparatus include electronic apparatuses such as a mobile phone, a mobile information terminal, and a medical device, electronic apparatuses including various electronic components such as a semiconductor element, a capacitor, a coil, and a cable, and electronic apparatuses in which electronic components are mounted on a circuit board. Such an electronic apparatus can include the electromagnetic wave shielding material as a constitutional member of an electronic component included in the device. In addition, as a constitutional member of the electronic apparatus, the electromagnetic wave shielding material can be disposed in the inside of the electronic apparatus or can be disposed as a cover material that covers the outside of the electronic apparatus. Alternatively, it can be three-dimensionally formed into a tubular shape, thereby being disposed as a cover material that covers the outside of the cable.

Examples of the usage form of the electromagnetic wave shielding material include a usage form in which a semiconductor package on a printed board is coated with an electromagnetic wave shielding material. For example, "Electromagnetic wave shielding technology in a semiconductor package" (Toshiba Review Vol. 67, No. 2 (2012) P. 8) discloses a method of obtaining a high shielding effect by electrically connecting a side via of an end part of a package substrate and an inner surface of an electromagnetic wave shielding material in a case where a semiconductor package is coated with an electromagnetic wave shielding material, thereby carrying out ground wiring. In order to carry out such wiring, it is desirable that the outermost layer of the electromagnetic wave shielding material on the electronic component side is a metal layer. In a case where one or both of the outermost layers of the electromagnetic wave shielding material is a metal layer in the electromagnetic wave shielding material, the electromagnetic wave shielding material can be suitably used in a case of carrying out the wiring as described above.

Examples

Hereinafter, the present invention will be described in more detail with reference to Examples. However, the present invention is not limited to the embodiments shown in Examples.

[Resin of magnetic layer]

The resin of the magnetic layer shown in Table 1 is the following resin.

Acrylic resin 1: acrylic rubber manufactured by Zeon Corporation under the trade name Nipol (model No. AR71)
Acrylic resin 2: acrylic rubber manufactured by Zeon Corporation under the trade name Nipol (model No. AR51).
Acrylic resin 3: trade name ethyl polyacrylate solution manufactured by Sigma-Aldrich Corporation
Acrylic resin 4: hexane re-precipitate of Acrylic resin 3
Acrylonitrile butadiene rubber (NBR): trade name Nipol manufactured by Zeon Corporation (model No. DN003)

The above-described Acrylic resin 4 was prepared by pouring a large amount of hexane into Acrylic resin 3 to precipitate Acrylic resin 3, separating and recovering the precipitate by filtration, and then subjecting the precipitate to vacuum drying in a vacuum dryer having an internal temperature of 80°C.

The weight-average molecular weight of each of the above-described resins was measured by gel permeation chromatography (GPC) as described below. The weight-average molecular weight thus obtained is listed in Table 1.

HLC (registered trademark)-8320GPC [manufactured by Tosoh Corporation] was used as a measuring device. TSKgel (registered trademark) Super HZ-H [4.6 mm ID x 15 cm, manufactured by Tosoh Corporation], Super HZ4000 [4.6 mm ID x 15 cm, manufactured by Tosoh Corporation], and Super HZ2000 [4.6 mm ID x 15 cm, Tosoh Corporation] were connected one by one in series and used as the column, and tetrahydrofuran (THF) was used as the eluent.

The measurement conditions were a specimen concentration of 0.2% by mass, a flow rate of 0.35 mL/min, a sample injection amount of 10 $\mu$L, and a measurement temperature of 40°C, and a differential refractive index (RI) detector was used as the detector.

The calibration curve was created using "Standard sample TSK standard, polystyrene", "F-288", "F-80", "F-20", "F-4", "F-2", "A-5000", and "A-1000", manufactured by Tosoh Corporation.

[Example 1]

<Preparation of composition for forming magnetic layer (coating liquid)>

To a plastic bottle, the following substances were added and mixed with a shaking type stirrer for 96 hours to prepare a coating liquid;

Fe-Si-Al flat-shaped magnetic particles (Sendust MFS-SUH manufactured by MKT): 10 g,
acrylic resin (see Table 1, concentration of solid contents: 100% by mass): 2.5 g, and
cyclohexanone: 36 g.

The content of the acrylic resin is 20 parts by mass, with respect to 100 parts by mass of the total mass of the magnetic layer formed of the prepared composition for forming a magnetic layer.

<Production of magnetic layer>

(Formation of film of magnetic layer)

A coating liquid was applied onto a peeling surface of a peeling-treated PET film (PET75-JOL manufactured by NIPPA Co., Ltd.) with a blade coater having a coating gap of 650 $\mu$m and dried for 8 minutes (hereinafter, "drying time") in a drying device having an internal atmospheric temperature of 90°C to form a film of a film-shaped magnetic layer on the peeling-treated PET film.

(Pressurization treatment of magnetic layer)

Upper and lower press plates of a plate-shape pressing machine (Mini Test Press, manufactured by Toyo Seiki Seisaku-sho, Ltd.) were heated to 140°C (internal temperature of press plate), and a magnetic layer obtained by peeling off the peeling-treated PET film was sandwiched between two sheets of Teflon (registered trademark) having a thickness of 1 mm and held for 10 minutes in a state where a pressure of 30 N/mm$^2$ was applied. The upper and lower press plates were cooled to 50°C (the internal temperature of the press plates) while maintaining the pressure, and then the magnetic layer was taken out from between the two Teflon (registered trademark) sheets. A measurement sample for various evaluations described later was cut out from a part of the obtained magnetic layer.

<Production of electromagnetic wave shielding material>

Using the magnetic layer obtained above as the magnetic layer and using an aluminum foil (JIS H4160: 2006 standard, alloy number: 1N30, temper designation: (1)O, Al content: 99.3% by mass or more) having a thickness of 30 $\mu$m as the metal layer, five layers of "aluminum foil (metal layer)/magnetic layer/aluminum foil (metal layer)/magnetic layer/aluminum foil (metal layer)" were laminated to produce a laminate, without interposing other layers between two layers adjacent to each other.

Upper and lower press plates of a plate-shape pressing machine (a large-scale hot press TA-200-1W manufactured by YAMAMOTO ENG. WORKS CO., LTD.) were heated to 140°C (the internal temperature of the press plate), and the laminate was installed in the center of the press plate and held for 10 minutes in a state where a pressure of 4.66 N/mm$^2$ was applied, whereby the aluminum foil and the magnetic layer were subjected to the thermal compression bonding. The upper and lower press plates were cooled to 50°C (the internal temperature of the press plates) while maintaining the pressure, and then the laminate was taken out from the plate-shape pressing machine.

In this way, an electromagnetic wave shielding material of Example 1 was obtained. The electromagnetic wave shielding material of Example 1 had a multilayer structure of "aluminum foil (metal layer)/magnetic layer/aluminum foil (metal layer)" twice.

[Evaluation method]

<Measurement of magnetic permeability before and after thermal aging at 80°C>

A measurement sample having a size of 28 mm $\times$ 10 mm was cut out from the magnetic layer, the magnetic permeability was measured using a magnetic permeability measuring apparatus (PER01 manufactured by KEYCOM Corporation), and the magnetic permeability was determined as the real part ($\mu'$) of the complex specific magnetic permeability at a frequency of 3 MHz (measurement temperature: 25°C). The magnetic permeability obtained in this way is defined as a "magnetic permeability before thermal aging at 80°C".

After the measurement sample after measuring the magnetic permeability before thermal aging at 80°C was disposed in a high temperature atmosphere of 80°C for 24 hours, the magnetic permeability was determined by the above method (measurement temperature: 25°C). The magnetic permeability obtained in this way is defined as a "magnetic permeability after thermal aging at 80°C".

Table 2 shows evaluation results obtained by evaluating "magnetic permeability before thermal aging at 80°C" and "magnetic permeability after thermal aging at 80°C" according to the following evaluation standards.

A: The magnetic permeability $\mu'$ is 100 or more.
B: The magnetic permeability $\mu'$ is 40 or more and less than 100.
C: The magnetic permeability $\mu'$ is less than 40.

<Measurement of electrical conductivity>

A cylindrical main electrode having a diameter of 30 mm was connected to the negative electrode side of a digital super-insulation resistance meter (TR-811A manufactured by Takeda RIKEN Industries), a ring electrode having an inner diameter of 40 mm and an outer diameter of 50 mm was connected to the positive electrode side thereof, the main electrode was installed on a sample piece of the magnetic layer cut to a size 60 mm × 60 mm, the ring electrode was installed at a position surrounding the main electrode, a voltage of 25 V was applied to both electrodes, and the surface electrical resistivity of the magnetic layer alone was measured. The electrical conductivity of the magnetic layer was calculated from the surface electrical resistivity and the following expression. The calculated electrical conductivity was 1.1 × $10^{-2}$ S/m.

As the thickness, the thickness of the magnetic layer, which had been determined according to the following method, was used.

$$\text{Electrical conductivity [S/m]} = 1/(\text{surface electrical resistivity } [\Omega] \times \text{thickness [m]})$$

<Acquisition of cross-sectional image of electromagnetic wave shielding material>

Cross-section processing was carried out to expose the cross-section of the electromagnetic wave shielding material by the following method.

An electromagnetic wave shielding material cut out to a size of 3 mm × 3 mm was embedded in a resin, and a cross section of the electromagnetic wave shielding material was cut out with an ion milling device (IM4000PLUS manufactured by Hitachi High-Tech Corporation).

The cross-section of the electromagnetic wave shielding material, which had been exposed in this way, was observed with a scanning electron microscope (SU8220, manufactured by Hitachi High-Tech Corporation) under the conditions of an acceleration voltage of 2 kV and a magnification of 100 times to obtain a backscattered electron image. From the obtained image, the thickness of each of the two magnetic layers and the thickness of each of the three metal layers were measured at five points, respectively, with the scale bar as a reference. The arithmetic average of the respective thicknesses was defined as the thickness of each magnetic layer, the thickness of each metal layer, and the total thickness of the electromagnetic wave shielding material. The thickness of each of the magnetic layers was 30 μm, and the thickness of each of the metal layers was 30 μm.

<Acquisition of cross-sectional image of magnetic layer>

In a cross section of the electromagnetic wave shielding material, which had been exposed by the cross-section processing in the same manner as described above, a portion of the magnetic layer was observed with a scanning electron microscope (SU8220, manufactured by Hitachi High-Tech Corporation) under the conditions of an acceleration voltage of 2 kV and a magnification of 1,000 times, thereby obtaining a backscattered electron image.

<Measurement of aspect ratio of magnetic particle and alignment degree of flat-shaped particle>

Using the backscattered electron image acquired as above, the aspect ratio of the magnetic particles was determined according to the method described above, and the flat-shaped particles were specified from the value of the aspect ratio. As a result of determining, as described above, whether or not the magnetic layer contained flat-shaped particles as the magnetic particles, it was determined that the magnetic layer contains flat-shaped particles. Further, as a result of determining the alignment degree of the magnetic particles specified as the flat-shaped particles, according to the method described above, the alignment degree was 13°. In addition, an average value (arithmetic average) of the aspect ratios of all the particles specified as the flat-shaped particles was determined as the aspect ratio of the flat-shaped particles contained in the magnetic layer. The determined aspect ratio was 0.071.

<Measurement of content of organic solvent in magnetic layer>

In an environment of an atmospheric temperature of 23°C, the content of the organic solvent in the magnetic layer was obtained by the following method.

The aluminum foil of one outermost layer of an electromagnetic wave shielding material cut into a size of 15 cm × 15 cm was peeled off with tweezers, and the exposed magnetic layer was scraped off to obtain a 0.5 g magnetic-layer sample.

The content of the organic solvent in the magnetic layer was obtained by the method described above using the obtained magnetic-layer sample. Table 1 shows the obtained amount of the organic solvent and the type of the organic solvent detected by HS-GC/MS measurement. The amount of each organic solvent was calculated according to the description in the reference described above.

The electromagnetic wave shielding material of Example 1 has two magnetic layers. Since the two magnetic layers were produced by the same method and the same treatment was performed for producing the electromagnetic wave shielding material, the measurement result regarding the organic solvent, which is obtained by the above method for one magnetic layer, can be adopted as the measurement result of the other magnetic layer.

<Evaluation of shielding ability before and after thermal aging at 80°C (KEC method)>

An electromagnetic wave shielding material cut to a size of 15 cm × 15 cm was installed between antennas of a KEC method evaluation device including a signal generator, an amplifier, a pair of magnetic field antennas, and a spectrum analyzer, and at a frequency of 100 kHz, a ratio of the intensity of the received signal in a case where the electromagnetic wave shielding material was not present to the intensity of the received signal in a case where the electromagnetic wave shielding material was present was determined and denoted as the shielding ability. The operation was carried out for the magnetic field antenna to obtain the electromagnetic wave shielding ability (magnetic field wave shielding ability). KEC is an abbreviation for Kansai Electronic Industry Development Center. The shielding ability evaluated according to the following evaluation standard from the value thus obtained is defined as "shielding ability before thermal aging at 80°C".
After the electromagnetic wave shielding material after measuring the shielding ability before thermal aging at 80°C was disposed in a high temperature atmosphere of 80°C for 24 hours, the shielding ability was determined by the above method. The shielding ability evaluated according to the following evaluation standard from the value thus obtained is defined as "shielding ability after thermal aging at 80°C".
The obtained evaluation results are shown in Table 2.

(Evaluation standards)

A: 30 dB or more
B: 25 dB or more and less than 30 dB
C: less than 25 dB

<Peel strength>

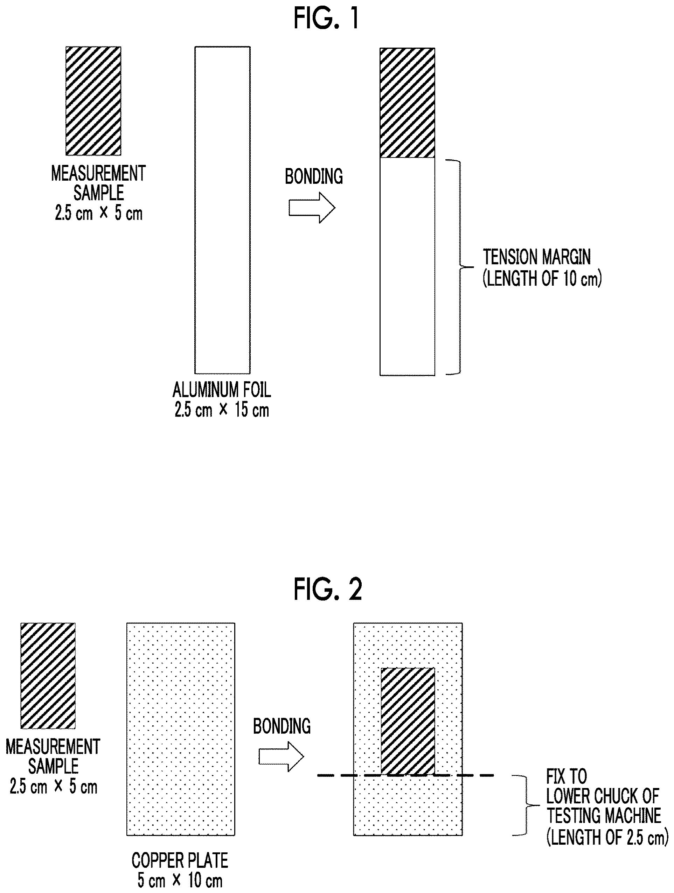

FIGS. 1 and 2 are explanatory views related to a measurement of peel strength.
The peel strength of the electromagnetic wave shielding material was measured by the following method.
A measurement sample having a short side length of 2.5 cm and a long side length of 5 cm was cut out from the electromagnetic wave shielding material having a size of 10 cm × 10 cm, from the vicinity of the center portion not to include the four edge surfaces of the electromagnetic wave shielding material.
An aluminum foil (manufactured by TAKEUCHI METAL FOIL & POWDER Co., LTD., model number: A1N30H-O, thickness: 50 μm) having a short side length of 2.5 cm and a long side length of 15 cm was prepared.
The metal layer (aluminum foil) of one outermost layer of the measurement sample and the aluminum foil were bonded to each other using an instant adhesive such that one short side of each of foils overlaps one another, thereby producing a tension margin. Such a tension margin is a portion of the aluminum foil, which has a length of 10 cm to which the measurement sample is not bonded (see FIG. 1).
Thereafter, a metal foil (copper foil) and a copper plate (manufactured by Hikari Co., Ltd., size: thickness of 1 mm, short side length of 5 cm, long side length of 10 cm) of the other outermost layer of the measurement sample (that is, the side on which the tension margin was not produced) were bonded using double-sided tape (see FIG. 2) by disposing the measurement sample on the center portion of the copper plate.
A portion of the copper plate to which the electromagnetic wave shielding material was not attached was fixed to a lower chuck of a testing machine (see FIG. 2).
Thereafter, the tension margin was folded at 180° and fixed to an upper chuck of the testing machine, and a peel test was performed under the following measurement conditions. The peel strength was calculated by dividing the load (unit: N (Newton)) obtained as a measured value by the short side length (2.5 cm).

(Measurement conditions)

Testing machine: a universal material testing instrument TENSILON (RTF-1310) manufactured by A&D Company, Limited.

Measurement environment: temperature of 23°C, relative humidity of 50%

Load cell: 500 newtons (N)
Tensile rate: 30 mm/min

The peel strength measured by the above-described method can be said to be an indicator of an adhesive force between two layers adjacent to each other in the laminate, and it can be said that the higher the value of the peel strength measured by the above-described method, the higher the adhesive force between the metal layer and the magnetic layer, and the better the durability of the electromagnetic wave shielding material. From the viewpoint of excellent durability, the peel strength measured by the above-described method is preferably 0.5 N/cm or more and more preferably 2.0 N/cm or more.

The durability of the electromagnetic wave shielding material was evaluated according to the following evaluation standards from the values obtained above. The evaluation results are shown in Table 2.

(Evaluation standards)

A: 2.0 N/cm or more
B: 0.5 N/cm or more and less than 2.0 N/cm
C: 0 N/cm or more and less than 0.5 N/cm

[Example 2]

An electromagnetic wave shielding material was produced and various evaluations were performed according to the method described for Example 1, except that the drying time in the film formation of the magnetic layer was changed to 15 minutes.

[Example 3]

An electromagnetic wave shielding material was produced and various evaluations were performed according to the method described for Example 1, except that the drying time in the film formation of the magnetic layer was changed to 30 minutes.

[Example 4]

An electromagnetic wave shielding material was produced and various evaluations were performed according to the method described for Example 1, except that the drying time in the film formation of the magnetic layer was changed to 120 minutes.

[Examples 5 to 7]

An electromagnetic wave shielding material was produced and various evaluations were performed according to the method described for Example 1, except that the acrylic resin shown in Table 1 was used and the drying time in the film formation of the magnetic layer was changed to 30 minutes.

[Example 8]

A magnetic layer was produced according to the method described for Example 1, except that the drying time in the film formation of the magnetic layer was changed to 30 minutes.

Using the magnetic layer obtained above as the magnetic layer and using an aluminum foil (JIS H4160: 2006 standard, alloy number: 1N30, temper designation: (1)O, Al content: 99.3% by mass or more) having a thickness of 30 $\mu$m as the metal layer, three layers of "aluminum foil (metal layer)/magnetic layer/aluminum foil (metal layer)" were laminated to produce a laminate, without interposing other layers between two layers adjacent to each other.

Upper and lower press plates of a plate-shape pressing machine (a large-scale hot press TA-200-1W manufactured by YAMAMOTO ENG. WORKS CO., LTD.) were heated to 140°C (the internal temperature of the press plate), and the laminate was installed in the center of the press plate and held for 10 minutes in a state where a pressure of 4.66 N/mm$^2$ was applied, whereby the aluminum foil and the magnetic layer were subjected to the thermal compression bonding. The upper and lower press plates were cooled to 50°C (the internal temperature of the press plates) while maintaining the pressure, and then the laminate was taken out from the plate-shape pressing machine.

In this way, an electromagnetic wave shielding material of Example 8 was obtained. The electromagnetic wave shielding material of Example 8 had a multilayer structure of "aluminum foil (metal layer)/magnetic layer/aluminum foil (metal layer)" once. In Example 8, various evaluations were performed by the method described for Example 1.

[Example 9]

An electromagnetic wave shielding material was produced and various evaluations were performed by the method described in Example 1, except that a copper foil (JIS H3100: 2018 standard, alloy number C1020R-H, Cu content of 99.9% by mass or more) having a thickness of 20 $\mu$m was used as the metal layer instead of the aluminum foil and the drying time in the film formation of the magnetic layer was changed to 30 minutes.

[Example 10]

An electromagnetic wave shielding material was produced and various evaluations were performed according to the method described for Example 1, except that the organic solvent of the composition for forming a magnetic layer was changed to methyl ethyl ketone and the drying time in the film formation of the magnetic layer was changed to 10 minutes.

[Example 11]

An electromagnetic wave shielding material was produced and various evaluations were carried out according to the method described for Example 1, except for the following points.
The drying time in the film formation of the magnetic layer was changed to 30 minutes.
Alpet 30-50 manufactured by PANAC Co., Ltd. (a laminate in which an aluminum foil (metal layer having an Al content of 99.0% by mass or more) having a thickness of 30 $\mu$m and a polyester film (resin layer) having a thickness of 50 $\mu$m were bonded to each other via an adhesive layer having a thickness of 3 $\mu$m) was used instead of the aluminum foil.
For the electromagnetic wave shielding materials of Examples 2 to 10, the thickness of each magnetic layer and each metal layer (aluminum foil or copper foil) was determined according to the method described for Example 1. In any of Examples, the thickness of each magnetic layer was 30 $\mu$m. The thickness of the metal layer (aluminum foil) was 30 $\mu$m, and the thickness of the metal layer (copper foil) was 20 $\mu$m.
In the electromagnetic wave shielding material of Example 11, the thickness of each layer was determined according to the method described for Example 1, and the thickness of each layer was the above-described thickness.

[Comparative Example 1]

An electromagnetic wave shielding material was produced and various evaluations were performed according to the method described for Example 1, except that the resin shown in Table 1 was used instead of the acrylic resin and the drying time in the film formation of the magnetic layer was changed to 30 minutes.

[Comparative Example 2]

A magnetic layer was produced according to the method described for Example 1, except that the drying time in the film formation of the magnetic layer was changed to 30 minutes.
Using the magnetic layer obtained above as the magnetic layer and using an aluminum foil (JIS H4160: 2006 standard, alloy number: 1N30, temper designation: (1)O, Al content: 99.3% by mass or more) having a thickness of 100 $\mu$m as the metal layer, two layers of "aluminum foil (metal layer)/magnetic layer" were laminated to produce a laminate, without interposing other layers.
Upper and lower press plates of a plate-shape pressing machine (a large-scale hot press TA-200-1W manufactured by YAMAMOTO ENG. WORKS CO., LTD.) were heated to 140°C (the internal temperature of the press plate), and the laminate was installed in the center of the press plate and held for 10 minutes in a state where a pressure of 4.66 N/mm$^2$ was applied, whereby the aluminum foil and the magnetic layer were subjected to the thermal compression bonding. The upper and lower press plates were cooled to 50°C (the internal temperature of the press plates) while maintaining the pressure, and then the laminate was taken out from the plate-shape pressing machine.
In this way, an electromagnetic wave shielding material of Comparative Example 2 was obtained. The electromagnetic wave shielding material of Comparative Example 2 consists of two layers of "aluminum foil (metal layer)/magnetic layer". In Comparative Example 2, various evaluations were performed by the method described for Example 1.

[Comparative Example 3]

An electromagnetic wave shielding material was produced and various evaluations were performed according to the method described for Example 1, except that in the film formation of the magnetic layer, the drying time was changed to 30 minutes and further, additional drying was performed for 2 hours in a vacuum dryer (internal atmospheric temperature: 80°C).

[Comparative Example 4]

An electromagnetic wave shielding material was produced and various evaluations were performed according to the method described for Example 1, except that the drying time in the film formation of the magnetic layer was changed to 5 minutes.

[Table 1]

| | Magnetic layer | | | | Layer configuration of electromagnetic wave shielding material |
|---|---|---|---|---|---|
| | Type of resin | Resin weight-average molecular weight | Type of organic solvent | Content of organic solvent (ppm) | |
| Example 1 | Acrylic resin 1 | 1,150,000 | Cyclohexanone | 966 | Aluminum foil/magnetic layer/aluminum foil/magnetic layer/aluminum foil |
| Example 2 | Acrylic resin 1 | 1,150,000 | Cyclohexanone | 95 | Aluminum foil/magnetic layer/aluminum foil/magnetic layer/aluminum foil |
| Example 3 | Acrylic resin 1 | 1,150,000 | Cyclohexanone | 16 | Aluminum foil/magnetic layer/aluminum foil/magnetic layer/aluminum foil |
| Example 4 | Acrylic resin 1 | 1,150,000 | Cyclohexanone | 6 | Aluminum foil/magnetic layer/aluminum foil/magnetic layer/aluminum foil |
| Example 5 | Acrylic resin 2 | 800,000 | Cyclohexanone | 21 | Aluminum foil/magnetic layer/aluminum foil/magnetic layer/aluminum foil |
| Example 6 | Acrylic resin 3 | 100,000 | Cyclohexanone | 22 | Aluminum foil/magnetic layer/aluminum foil/magnetic layer/aluminum foil |
| Example 7 | Acrylic resin 4 | 80,000 | Cyclohexanone | 25 | Aluminum foil/magnetic layer/aluminum foil/magnetic layer/aluminum foil |
| Example 8 | Acrylic resin 1 | 1,150,000 | Cyclohexanone | 19 | Aluminum foil/magnetic layer/aluminum foil |
| Example 9 | Acrylic resin 1 | 1,150,000 | Cyclohexanone | 25 | Copper foil/magnetic layer/copper foil/-magnetic layer/copper foil |
| Example 10 | Acrylic resin 1 | 1,150,000 | Methyl ethyl ketone | 44 | Aluminum foil/magnetic layer/aluminum foil/magnetic layer/aluminum foil |
| Example 11 | Acrylic resin 1 | 1,150,000 | Cyclohexanone | 11 | Aluminum foil/adhesive layer/resin layer/-magnetic layer/resin layer/adhesive layer/aluminum foil/magnetic layer/resin layer/adhesive layer/aluminum foil |
| Comparative Example 1 | NBR | 260,000 | Cyclohexanone | 30 | Aluminum foil/magnetic layer/aluminum foil/magnetic layer/aluminum foil |
| Comparative Example 2 | Acrylic resin 1 | 1,150,000 | Cyclohexanone | 14 | Aluminum foil/magnetic layer |
| Comparative Example 3 | Acrylic resin 1 | 1,150,000 | Cyclohexanone | 1 | Aluminum foil/magnetic layer/aluminum foil/magnetic layer/aluminum foil |

(continued)

| | Magnetic layer | | | | Layer configuration of electromagnetic wave shielding material |
|---|---|---|---|---|---|
| | Type of resin | Resin weight-average molecular weight | Type of organic solvent | Content of organic solvent (ppm) | |
| Comparative Example 4 | Acrylic resin 1 | 1,150,000 | Cyclohexanone | 1048 | Aluminum foil/magnetic layer/aluminum foil/magnetic layer/aluminum foil |

[Table 2]

| | Transmittance μ' | | Peel strength | Shielding ability (100 kHz) | |
|---|---|---|---|---|---|
| | 80°C before thermal aging | 80°C before thermal aging | | 80°C before thermal aging | 80°C before thermal aging |
| Example 1 | A | A | B | A | A |
| Example 2 | A | A | A | A | A |
| Example 3 | A | A | A | A | A |
| Example 4 | A | A | B | A | A |
| Example 5 | A | A | A | A | A |
| Example 6 | A | B | A | A | B |
| Example 7 | A | B | B | A | B |
| Example 8 | A | A | A | B | B |
| Example 9 | A | A | A | A | A |
| Example 10 | A | A | A | A | A |
| Example 11 | A | A | A | A | A |
| Comparative Example 1 | A | C | A | A | C |
| Comparative Example 2 | A | A | A | C | C |
| Comparative Example 3 | A | A | C | A | A |
| Comparative Example 4 | A | B | C | A | A |

From the results shown in Table 2, it can be confirmed that the electromagnetic wave shielding materials of Examples 1 to 11 have excellent heat resistance and durability.

Industrial Applicability

One aspect of the present invention is useful in the technical fields of various electronic components and various electronic apparatuses.

**Claims**

1. An electromagnetic wave shielding material comprising:

a magnetic layer containing magnetic particles and an acrylic resin between two metal layers, wherein a content of an organic solvent in the magnetic layer is 5 ppm or more and less than 1,000 ppm on a mass basis.

2. The electromagnetic wave shielding material according to claim 1, wherein a weight-average molecular weight of the acrylic resin is 100,000 or more.

3. The electromagnetic wave shielding material according to claim 1,
   wherein a weight-average molecular weight of the acrylic resin is 800,000 or more and 2,000,000 or less.

4. The electromagnetic wave shielding material according to claim 1,
   wherein the content of the organic solvent in the magnetic layer is 10 ppm or more and 100 ppm or less.

5. The electromagnetic wave shielding material according to claim 1,
   wherein the organic solvent is selected from the group consisting of methyl ethyl ketone and cyclohexanone.

6. The electromagnetic wave shielding material according to claim 1, further comprising:
   one or more layers containing a resin between the magnetic layer sandwiched between the two metal layers and one or both of the two metal layers.

7. The electromagnetic wave shielding material according to claim 1,
   wherein the electromagnetic wave shielding material has two or more multilayer structures that include the magnetic layer between the two metal layers.

8. The electromagnetic wave shielding material according to claim 1,
   wherein one or more of the metal layers are metal layers having a Cu content of 80.0% by mass or more.

9. The electromagnetic wave shielding material according to claim 1,
   wherein one or more of the metal layers are metal layers having an Al content of 80.0% by mass or more.

10. The electromagnetic wave shielding material according to claim 1,

    wherein a weight-average molecular weight of the acrylic resin is 800,000 or more and 2,000,000 or less,
    the content of the organic solvent in the magnetic layer is 10 ppm or more and 100 ppm or less,
    the organic solvent is selected from the group consisting of methyl ethyl ketone and cyclohexanone,
    the electromagnetic wave shielding material has two or more multilayer structures that include the magnetic layer between the two metal layers, and
    one or more of the metal layers are metal layers having a Cu content of 80.0% by mass or more.

11. The electromagnetic wave shielding material according to claim 1,

    wherein a weight-average molecular weight of the acrylic resin is 800,000 or more and 2,000,000 or less,
    the content of the organic solvent in the magnetic layer is 10 ppm or more and 100 ppm or less,
    the organic solvent is selected from the group consisting of methyl ethyl ketone and cyclohexanone,
    the electromagnetic wave shielding material has two or more multilayer structures that include the magnetic layer between the two metal layers, and
    one or more of the metal layers are metal layers having an Al content of 80.0% by mass or more.

12. An electronic component comprising:
    the electromagnetic wave shielding material according to any one of claims 1 to 11.

13. An electronic apparatus comprising:
    the electromagnetic wave shielding material according to any one of claims 1 to 11.

# FIG. 1

MEASUREMENT
SAMPLE
2.5 cm × 5 cm

ALUMINUM FOIL
2.5 cm × 15 cm

BONDING

TENSION MARGIN
(LENGTH OF 10 cm)

# FIG. 2

MEASUREMENT
SAMPLE
2.5 cm × 5 cm

COPPER PLATE
5 cm × 10 cm

BONDING

FIX TO
LOWER CHUCK OF
TESTING MACHINE
(LENGTH OF 2.5 cm)

## INTERNATIONAL SEARCH REPORT

| International application No. |
| --- |
| **PCT/JP2024/008284** |

**A. CLASSIFICATION OF SUBJECT MATTER**

*H05K 9/00*(2006.01)i; *B32B 15/20*(2006.01)i; *B32B 15/082*(2006.01)i; *B32B 27/18*(2006.01)i; *B32B 27/30*(2006.01)i; *H01F 1/26*(2006.01)i

FI:  H05K9/00 W; H01F1/26; B32B15/082 Z; B32B27/18 H; B32B27/30 A; B32B15/20

According to International Patent Classification (IPC) or to both national classification and IPC

**B. FIELDS SEARCHED**

Minimum documentation searched (classification system followed by classification symbols)

H05K9/00; B32B15/20; B32B15/082; B32B27/18; B32B27/30; H01F1/26

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2022/138701 A1 (FUJIFILM CORPORATION) 30 June 2022 (2022-06-30) paragraphs [0043]-[0044], [0047], [0049], [0057], [0077]-[0078], [0089]-[0090] | 1-13 |
| A | JP 2018-88510 A (SUMITOMO METAL MINING CO., LTD.) 07 June 2018 (2018-06-07) | 1-13 |
| A | JP 2001-358493 A (HITACHI, LTD.) 26 December 2001 (2001-12-26) | 1-13 |
| A | JP 2020-150036 A (FUJIKURA KASEI CO., LTD.) 17 September 2020 (2020-09-17) | 1-13 |
| A | WO 2022/050424 A1 (DENKA CO., LTD.) 10 March 2022 (2022-03-10) | 1-13 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **09 April 2024** | **23 April 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/008284**

| Patent document cited in search report | | | Publication date (day/month/year) | Patent family member(s) | | | Publication date (day/month/year) |
|---|---|---|---|---|---|---|---|
| WO | 2022/138701 | A1 | 30 June 2022 | US | 2023/0328944 | A1 | |
| | | | | paragraphs [0058]-[0060], [0063]-[0064], [0066], [0075]-[0077], [0111]-[0113], [0128]-[0131] | | | |
| | | | | EP | 4271156 | A1 | |
| | | | | CN | 116761714 | A | |
| JP | 2018-88510 | A | 07 June 2018 | (Family: none) | | | |
| JP | 2001-358493 | A | 26 December 2001 | US | 2003/0190498 | A1 | |
| | | | | US | 2005/0140539 | A1 | |
| | | | | EP | 1146591 | A2 | |
| | | | | KR | 10-2001-0090788 | A | |
| | | | | CN | 1336793 | A | |
| JP | 2020-150036 | A | 17 September 2020 | (Family: none) | | | |
| WO | 2022/050424 | A1 | 10 March 2022 | EP | 4212646 | A1 | |
| | | | | CN | 115667581 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010097969 A
- JP 2018131640 A

- JP 2015187260 A

**Non-patent literature cited in the description**

- Electromagnetic wave shielding technology in a semiconductor package. *Toshiba Review*, 2012, vol. 67 (2), 8